# EUROPEAN PATENT SPECIFICATION

(11) **EP 4 572 956 B1**
(45) Date of publication and mention of the grant of the patent: **15.07.2026**
(21) Application number: 23754790.6
(22) Date of filing: 10.08.2023
(51) Int. Cl.: B32B 19/04, B32B 15/04, B32B 15/18, B32B 15/20, B32B 3/28, B32B 3/10, B32B 7/12, B32B 3/14, E04B 5/00, E04F 15/00

(54) **FLOOR STRUCTURE**
BODENSTRUKTUR
STRUCTURE DE PLANCHER

(30) Priority: 15.08.2022 EP 22190425
(43) Date of publication of application: 25.06.2025
(73) Proprietor: Sika Technology AG, 6340 Baar (CH)
(72) Inventor: BOS, Michiel, 9685 AB Blauwestad (NL); ESKILDSEN, Per, 4000 Roskilde (DK); JOERGENSEN, Carsten Allan Langeskov, 2635 Ishoej (DK); OVEJERO, Oscar, 8907 Wettswil am Albis (CH)
(74) Representative: Sika Patent Attorneys
(86) International application number: PCT/EP2023/072152
(87) International publication number: WO 2024/037959

(56) References cited:
- EP-A1- 1 739 246
- EP-A1- 2 122 081
- EP-A1- 2 993 037
- WO-A1-2017/053618

## Description

### Technical field

The invention relates to a floor structure comprising a supporting element, an insulating layer and a constraining layer as well to as a vehicle, a building and/or an offshore installation, especially a ship, comprising such a floor structure. Furthermore, the invention is concerned with a method for the production of a floor structure and the use of the floor structure for acoustic damping or in a fire protection system, especially in a vehicle, a building and/or an offshore installation.

### Background art

In vehicles, buildings, or offshore installations, the transmission of undesired sound or vibrations trough structural elements such as floors is a challenging problem. This is in particular true in metal-based constructions, such as e.g. railways, ships and offshore installations, with large flat areas.

As a consequence, flat areas such as floors are not only expected to be smooth and level, but to play a major part in noise and vibration suppression. On board of ships, for example, there are several dominant sound and vibration sources like diesel engines, gearboxes and propellers that transmit these kinds of energy. In the domain of acoustic and vibration engineering, the energy released by these sources are defined in two ways:
- Vibration: Dynamic movements in solids and liquids
- Sound: Variations in air pressure in the audible frequency range (20 Hz-20 kHz)

On a ship, the most dominant transmission of undesirable sound or noise is through the structure of the ship. The engine, the propeller, the gearbox etc. each creates energy waves that transmit as structure-borne noise into the air from the large flat areas, such as e.g. decks and bulkheads, that act as sounding boards.

Airborne noise is less dominant as sounds carried along companionways and laterally through partitions and bulkheads reduce substantially with the distance from the source.

In order to reduce vibrations and noise, viscoelastic damping systems can be applied directly onto vibrating areas or surfaces. These systems reduce the radiation of low frequency noise and transform the vibrations from kinetic energy into heat.

Besides vibration and sound dampening in vehicles, buildings, or offshore installations, another important aspect is the prevention of the spread of fire. Typically, this is achieved via (i) passive fire protection, e.g. the installation of firewalls and fire rated floor assemblies to form fire compartments intended to limit the spread of fire, high temperatures, and smoke or via (ii) active fire protection, e.g. manual and automatic detection and suppression of fires, for example with fire sprinkler systems and/or alarm systems.

For example, WO 2020/225300 A1 (Sika Technology AG) describes a mortar composition for acoustic damping and fire protection. The mortar can for example be used to produce structures of floors, walls, or ceilings, which comprise on a metallic support element a special mortar composition, steel plates, an insulating layer of mineral wool and a covering.

However, known floor structures usually have a high density and as such increase the overall weight of vehicles, buildings, or offshore installations. Floor structures with a lower density are possible, but then the mechanical load capacity decreases.

For example, WO 2017/053618 A1 (Storm Strong LLC) discloses a panel to be used in a floor structure for improving resistance of a building against high winds and surging water, as it might occur during strong storms.

There is thus still a need to develop improved floor systems that overcome the aforementioned drawbacks.

### Disclosure of the invention

It is an object of the present invention to provide improved floor structures for vehicles, buildings, and/or offshore installations. Especially, the floor structures should preferably be suitable for acoustic damping and/or fire protection, have a high load capacity and/or be of light weight. The floor structures should in particular be suitable for marine applications, industrial buildings and/or railway rolling stock.

Surprisingly, it has been found that these objects are achieved by the features of claim 1. Thus, the core of the invention is a floor structure comprising:
(i) a supporting element, especially made of metal;
(ii) an insulating layer made of mineral wool;
(iii) a constraining layer made of a metal sandwich structure comprising a first and a second metal cover layer, whereby between the first and the second cover layer a core layer having a corrugated structure is arranged, such that between the first cover layer and the core layer first channels and between the second cover layer and the core layer second channels are formed,
characterized in that said insulating layer is arranged between said supporting element and said constraining layer.

Such floor structures are capable of absorbing noise, especially in the frequency range of 50 - 5'000 Hz, e.g. in automotive and marine applications. Thus, the inventive structures are highly suitable for acoustic damping, e.g. in vehicles, buildings, and/or offshore installations, in particular in ships.

Additionally, the inventive structures are highly suitable as passive fire protection systems, e.g. as fire barriers, to limit the spread of fire. Specifically, floor structures which meet class "A-60" according to FTP Code (International code for application of fire test procedures) can be produced easily.

Since the floor structure does not require massive metal plates, e.g. steel plates, the weight or areal density, respectively, of the floor structures is rather low. Nevertheless, thanks to the special metal sandwich structure, the constraining layer has a high stability. This helps to reduce the overall weight of vehicles, buildings, and/or offshore installations while maintaining a high load capacity. For vehicles, the lower weight results in a reduced energy or fuel consumption. This is in particular relevant for heavy vehicles, such as trains, cargo ships, cruise ships and/or ferries.

Whereas the weight of a traditional floating floor is about 42 kg/m², a comparable inventive floor can be produced with a weight of only 14 kg/m².

Additionally, the inventive floor structures can be installed in a rather easy and fast manner since no heavy massive elements are required.

Additional aspects of the invention are subject of further independent claims. Particularly preferred embodiments are outlined throughout the description and the dependent claims.

### Ways of carrying out the invention

A first aspect of the present invention is directed to a floor structure comprising:
(i) a supporting element, especially made of metal;
(ii) an insulating layer made of mineral wool;
(iii) a constraining layer made of a metal sandwich structure comprising a first and a second metal cover layer, whereby between the first and the second cover layer a core layer having a corrugated structure is arranged, such that between the first cover layer and the core layer first channels and between the second cover layer and the core layer second channels are formed,
characterized in that said insulating layer is arranged between said supporting element and said constraining layer.

The supporting element carries the other layers of the floor structure.

In particular, the supporting element is made of metal, in particular made of steel and/or aluminum. Especially, the supporting element has a flat upper surface, whereby the other layers of the floor structure are arranged on the flat upper surface of the supporting element.

For example, the supporting element is a deck of a ship or an offshore installation.

The insulating layer is arranged between the supporting element (supporting layer) and the constraining layer. This allows for protecting the insulating layer form mechanical damage with the constraining layer and realizing a floating floor arrangement.

Especially, the insulating layer is arranged in a floating manner on the layer directly below the insulating layer, especially on the supporting layer or on an optional intermediate layer. This means that the insulating layer is not fixed to the layer directly below it, especially the supporting layer. As it turned out, a floating arrangement allows for reducing stress in the floor structure and improving the acoustic damping properties.

The insulating layer is made of mineral wool.

In particular, "mineral wool" stands for any fibrous material formed by spinning or drawing molten mineral or rock materials, such as e.g. stone, glass, slag and/or ceramics. Especially, the mineral wool is present on the form of fabric, preferably consisting to an extent of at least 75 wt.%, preferably at least 90 wt.% or 95 wt.% of fibrous material consisting of stone, glass, slag and/or ceramics.

Especially preferred, the insulating layer comprises or consist of stone wool, slag wool and/or glass wool.

The insulating layer preferably is made of mineral wool with an area density of 3 - 10 kg/m², especially 4 - 8 kg/m², for example 5 kg/m² or 7 kg/m².

A nominal density of the mineral wool, measured according to EN 1602:2013, preferably is 70 - 200 kg/m³, preferably 90 - 190 kg/m³, in particular 100 - 170 kg/m³, especially 120 - 150 kg/m², for example 140 kg/m³.

The insulating layer in particular is made of mineral wool with a compressive strength, measured according to EN 826:2013, of at least 4 kPa, preferably at least 7 kPa, in particular at least 10 kPa, especially at least 12 kPa.

Preferably, the insulating layer is made of mineral wool with a thickness, measured in direction perpendicular to the support element, of 30 - 150 mm, especially 40 - 100 mm, in particular 45 - 60 mm, for example 50 mm.

Especially, a thickness of the insulating layer is larger than the thickness of the constraining layer.

Furthermore, in particular, the insulating layer is made of mineral wool having a dynamic stiffness, measured according to EN 229052-1:1992, of 3 - 20 MN/m³, preferably 8 - 19 MN/m³, especially 10 - 17 MN/m³, in particular 12 - 16 MN/m³, for example 14 MN/m³.

Mineral wool with these properties turned out to be highly suitable for achieving the above-mentioned objects, especially with regard to acoustic damping, fire protection and mechanical load capacity.

Especially, the insulating layer is made of several individual insulating plates, especially rectangular plates that are arranged side by side such that a continuous insulating layer is formed. In this case, the insulating layer can be built up manually in a rather easy manner without need of special tools or machines.

For example:
- a length of the individual insulating plates is 500 - 2000 mm, especially 750 - 1250 mm, and/or
- a width of the individual insulating plates is 200 - 1000 mm, especially 400 - 800 mm, and/or
- a thickness the individual insulating plates is 30 - 150 mm, especially 40 - 100 mm, in particular 45 - 60 mm, for example 50 mm.

Thereby, the length typically is larger than the width and the width is larger than the thickness.

In the metal sandwich structure, the cover layers in particular are mechanically fixed to the core layer, especially materially bonded. In particular, the cover layers are welded and/or adhesively bonded, most preferably welded, to the core layer. Thereby, in particular, the cover layers are selectively bonded to ridges of the corrugated core layer.

Preferably, the metal sandwich structure comprises 3 - 20 channels per meter, especially 4 - 15 channels per meter, whereby the channels include the total of the first and the second channels.

The first and/or second channels preferably are open at both ends. Nevertheless, closed configurations can be used as well if desired.

Especially, the channels are arranged in parallel. Thereby, in particular, the first channels are located in between second channels.

Especially the first and second channels run in a direction in parallel to the first and/or the second cover layer through the sandwich structure.

The first and/or second channels preferably are straight. However, other configurations might be suitable for special applications.

The core layer of the metal sandwich structure has a corrugated structure. A corrugated structure does not necessarily mean a structure having a regular waveform, for example a sinusoidal structure, having regularly formed valleys and ridges. A corrugated structure includes structures with arbitrarily formed valleys and ridges.

Preferably, the first metal cover layer, the second metal cover layer and/or the core layer having a corrugated structure is/are made of aluminum. Especially, the metal sandwich structure is made of aluminum completely. Since aluminum is rather lightweight and chemically inert towards many substances, aluminum is an ideal choice. However, in principle, one, more or all of the components of the metal sandwich structure can be made of other metals, such as e.g. steel. This might be desirable for special applications.

A thickness of the constraining layer and/or the metal sandwich structure preferably is 2 - 25 mm, especially 3 -15 mm, in particular 5 - 10 mm. The thickness in particular is measured in a direction perpendicular to the supporting element.

In the metal sandwich structure, the first and the second cover layer preferably are arranged plane parallel.

Preferably, a thickness of the first metal cover layer and/or the second metal cover layer is 0.5 - 2 mm, especially 0.7 - 1.3 mm, in particular 0.9 -1.1 mm.

A thickness of the core layer in particular is 0.1 - 0.5 mm, especially 0.2 - 0.4 mm, for example 0.3 mm.

Especially, a thickness of the first metal cover layer and/or the second metal cover layer is larger than the thickness of the core layer.

Especially preferred, the core layer, in a plane perpendicular to the longitudinal axes of the channels has a wave-shaped cross section, in particular a sinusoidal cross-section, a repeating trapezoidal cross-section, a repeating triangular cross-section or a repeating rectangular cross-section. Especially preferred, the core layer, in a plane perpendicular to the longitudinal axes of the channels has a sinusoidal cross-section.

Metal sandwich structures with such core layers are highly stable while having a rather low weight and good sound insulating properties

However, other core layers having for example arbitrary polygon train cross-sections are possible as well.

Preferably, an area density of the metal sandwich structure is 4 - 10 kg/m², especially 6 - 8 kg/m².

Most preferably, the constraining layer is made of several individual plates having a metal sandwich structure. The several individual plates are preferably arranged side by side such that a closed layer is formed.

In this case, the constraining layer can be built up manually in a rather easy manner without need of special tools or machines.

For example:
- a length of the individual plates having a metal sandwich structure is 1000 - 3000 mm, especially 1500 - 2500 mm, and/or
- a width of the individual plates having a metal sandwich structure is 200 - 2000 mm, especially 500 - 1400 mm, and/or
- a thickness the plates having a metal sandwich structure is 2 - 25 mm, especially 3 - 15 mm, in particular 5 - 10 mm.

Thereby, the length typically is larger than the width and the width is larger than the thickness.

Especially preferred, the individual plates are connected to each other, in particular with a tongue and groove connection. Thereby, the individual plates are in particular adjusted with regard to their height. This makes it possible to obtain highly flat constraining layer even if it is made of several individual plates.

In particular, the individual plates on each side comprise a groove within a sidewall in which a metal tongue is placed that extends into the groove of a neighboring plate. This allows for connecting the plates in a space saving manner without any protruding elements.

In a further preferred embodiment, between the mineral wool of the insulating layer and the metal sandwich structure of the constraining layer, metal stripes, especially aluminum stripes, are arranged in a grid-like manner, especially in a rectangular grid. The metal stripes preferably are adhesively bonded to the metal sandwich structure, especially with a polyurethane adhesive.

Put differently, if present, the metal stripes are arranged in an additional layer in between the insulating layer and the constraining layer. Thereby preferably, die metal stripes on one side are in direct contact with the insulation layer, especially the mineral wool, and on the other side in contact with the constraining layer, especially the sandwich structure, via the adhesive.

A coverage of the metal stripes preferably is 5 - 50%, especially 10 - 30%, of the total surface area of the insulating layer.

In particular, a width of the metal stripes is 50 - 250 mm, especially 100 - 200 mm, in particular 120 - 160 mm and/or a thickness of the metal stripes 0.5 - 5 mm, especially 1 - 3 mm.

The metal stripes can be used to reduce lateral movement of the constraining layer on the insulating layer. Furthermore, they stabilize the constraining layer.

If the constraining layer is made of several individual plates as described above, the metal stripes are preferably arranged such that neighboring individual plates having a metal sandwich structure are connected via at least one metal stripe, in particular at the lower side of the plates. In this case, preferably, the metal stripes run along the lines of contact between the individual plates. Thereby, the individual metal stripes stabilize the arrangement of the severely individual plates of the constraining layer.

The metal stripes can be used in addition to the tongue and groove connection as described above

In a further preferred embodiment, in between the supporting element and the insulating layer, at least one interlayer is arranged, whereby the interlayer is selected from a primer, a mortar and/or metal tiles, e.g. steel tiles. This allows for further adapting the floor structure to special requirements. For example, the acoustic dampening might be further improved, the fire protection might be enhanced and/or the insulating layer might be bonded to the supporting element.

However, in general, an interlayer is not necessary. Thus, the insulating layer can be in direct contact with the supporting element.

Especially, if a mortar is used, it preferably is a self-levelling cementitious mortar, in particular a polymer modified cementitious mortar. For example a mortar as described in WO 2020/225300 A1 can be used.

In a further preferred embodiment, on top of the constraining layer, at least one covering layer is arranged. Thereby, the covering layer is for example selected from organic membranes, organic resins and/or tiles. This allows for adapting the floor surface to specific needs.

The organic resin is for example selected from polyurethane resins and/or epoxy resins. Tiles might be selected from metal tiles, e.g. steel tiles.

In particular, the metal sandwich structure of the constraining layer is arranged such that it does not directly contact the supporting element and/or a side wall, especially all side walls, adjoining the supporting element. This allows to further improving acoustic damping.

This can e.g. be achieved, if the area of the constraining layer is smaller, e.g. at least 0.5% smaller, than the area of the insulating layer.

Especially preferred, the constraining layer, in particular on all sides, is spaced from the at least one side wall by at least 5 mm, especially at least 10 mm or at least 25 mm.

Further preferred, an outer boundary of the floor, especially a boundary adjoining a wall, is sealed with a sealant. The sealant might be a watertight sealant, e.g. a sealant based on a silane terminated polymer. This prevents for example liquids to be taken up into the floor structure.

A further aspect of the invention is related to a vehicle, a building and/or an offshore installation comprising a floor structure as described above.

The vehicle in particular is a train or a ship. A ship might be for example a cargo ship, a cruise ship or a ferry.

Disclosed is a method for the production of a floor structure as described above comprising the steps of:
(i) Placing an insulating layer made of mineral wool on a supporting element;
(ii) On top of the insulating layer, placing a constraining layer made of a metal sandwich structure comprising of a first and a second metal cover layer, whereby between the first and the second cover layer a core layer having a corrugated structure is arranged such that between the first cover layer and the core layer and between the second cover layer and the core layer channels are formed.

The supporting element, the insulating layer and the constraining layer made of a metal sandwich structure are defined as described above in connection with the inventive floor structure. Optional features of components of the floor structure and/or of the floor structure as a whole and described above as preferred, are in particular likewise realized in the inventive method.

In an especially preferred implementation, after step (i) metal stripes, especially aluminum stripes, are arranged in a grid-like manner on the insulating layer, and the upper side of the metal stripes are coated with an adhesive, especially with a polyurethane adhesive, such that when placing the constraining layer in step (ii), the constraining layer is adhesively bonded to the metal stripes.

In particular, before step (i), the supporting element is coated with at least one interlayer, whereby the interlayer is selected from a primer, a mortar and/or metal tiles.

In another preferred implementation, after step (ii), at least one covering layer is arranged on the constraining layer, whereby the covering layer preferably is selected from organic resins and tiles.

Advantages and further details of the metal stripes, the interlayers and coatings are described above in connection with the inventive floor structure.

As still further aspect of the present invention is directed to the following uses:
- The use of a floor structure as described above for acoustic damping, in particular in a vehicle, a building and/or an offshore installation, especially in a ship.
- The use of a floor structure as described above in a fire protection system, especially as a firewall and/or a fire barrier, in particular in a vehicle, a building and/or an offshore installation, especially in a ship

In particular, the floor structure as described above is used in combination for acoustic damping and in a fire protection system, especially as a firewall and/or a fire barrier.

The vehicle in particular is a train or a ship. A ship might be for example a cargo ship, a cruise ship or a ferry.

Further advantageous configurations of the invention are evident from the exemplary embodiments.

### Brief description of the drawings

The drawings used to explain the embodiments show:
- Fig. 1: a section of a first inventive floor structure in the form of a steel deck of a ship that is covered with an insulating layer of mineral wool and a constraining layer made of an aluminum sandwich structure in a perspective view;
- Fig. 2: a perspective view of a section of the aluminum sandwich structure of the floor structure of Fig. 1;
- Fig. 3: a top view on an enlarged section of the floor structure of Fig. 1;
- Fig. 4: a cross-section of the floor structure of Fig. 1 along line A - A in Fig. 1;
- Fig. 5: a cross-section of a further floor structure that is similar in design as the floor structure of Fig. 1 but has an additional covering layer in the form of a watertight polyurethane-based resin on top of the constraining layer;
- Fig. 6: a cross-section of another floor structure that is similar in design as the floor structure of Fig. 5 but additionally has a two-layer interlayer between the steel deck and the insulating layer.

In principle, parts identical in design are provided with the same reference numbers in the figures.

### Exemplary embodiments

### Floor structures

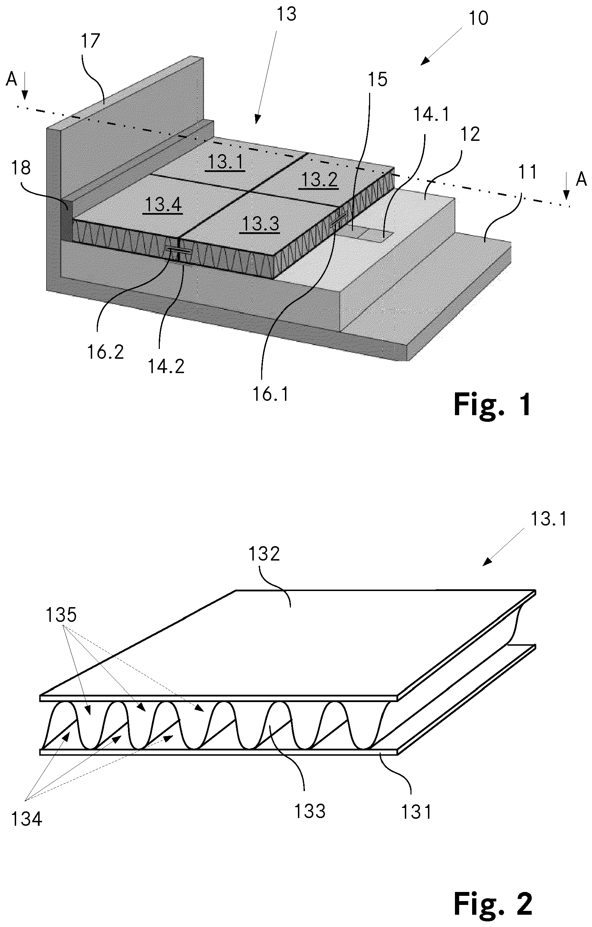

Fig. 1 shows a section of first inventive floor structure 10 in a perspective view.

The structure comprises a support element 11 in the form of a steel deck of a ship. On top of the support element 11, plates of a mineral wool (6.9 kg/m²; length × width × height of each plate: 2000 mmm × 1000 mm × 50 mm; e.g. Rockwool Searox SL436, available from Rockwool International A/S) are arranged as an insulating layer 12.

On top of the insulating layer 12, a rectangular grid of aluminum stripes 14.1, 14.2, ..., 14.12 is arranged (in Fig. 1 only two of the stripes are shown; cf. Fig. 2 for more details). The aluminum stripes have for example a size of 1000 mm × 140 mm × 2 mm. The upper sides of the aluminum stripes 14.1, 14.2, ..., 14.2 are coated with an adhesive 15, in particular a polyurethane adhesive (e.g. SikaForce^{®}-472 FR L 60; available from Sika Germany).

On Top of the insulating layer 12 and the aluminum stripes 14.1, 14.2, ..., 14.12, a constraining layer 13 made of several rectangular plates 13.1, 13.2, 13.3, 13.4, ..., 13.9 having a metal sandwich structure is arranged (in Fig. 1 only four plates are shown; Fig. 2 shows an enlarged view with more of the plates visible). The aluminum stripes 14.1, 14.2, ...14.12 run along a line of contact between neighboring plates. Thereby, neighboring plates 13.2, 13.3 are adhesively bonded to the same aluminum stripe 14.1 with an adhesive 15. Plates 13.3, 13.4 are adhesively bonded to another aluminum stripe 14.2 in a similar manner. The other plates are bonded to further aluminum stripes similarly (cf. Fig. 2).

Furthermore, neighboring plates 13.2, 13.3 are connected with an aluminum tongue 16.1 that is received in two opposing grooves in sidewalls of plates 13.2, 13.3. Plates 13.3, 13.4 are interconnected via another aluminum tongue 16.2 in a similar manner. Further connections exist between the further plates (not shown in Fig. 1). The floor structure of Fig. 1 has for example weight of 14.9 kg/m² (excluding the steel deck).

At the upper left side of Fig. 1, a side wall 17 protrudes from the steel deck 11. The insulating layer 12 is indirect contact with the side wall 17 whereas the constraining layer 13 is separated from the side wall 17 with a sealant element 18 (e.g. made from Sikaflex^{®}-591, available from Sika Germany). Therefore, there is no direct contact between die side wall 17 and the constraining layer 13.

Fig. 2 shows a section of one of the plates 13.1 having a metal sandwich structure. The plate consists of a first aluminum cover layer 131 and a second aluminum cover layer 132, whereby between the cover layers 131, 132 a core layer 133 made of aluminum and having a sinusoidal structure is arranged, such that between the first cover layer 131 and the core layer 133 first channels 134 and between the second cover layer 132 and the core layer 133 second channels 135 are formed. The channels 134, 135 all run in parallel to the cover layers 131, 132 as well as to each other. At the points of contact between the core layer 133 and the cover layers 131, 132, the core layer 133 is welded to the first core layer 131 or the second core layer 132.

A thickness of the first layer 131 and the second layer 132 is for example 1 mm whereas the thickness of the core layer 133 e.g. is 0.3 mm. The overall height of the plates is for example 6 mm and the area density is 6.9 kg/m³.

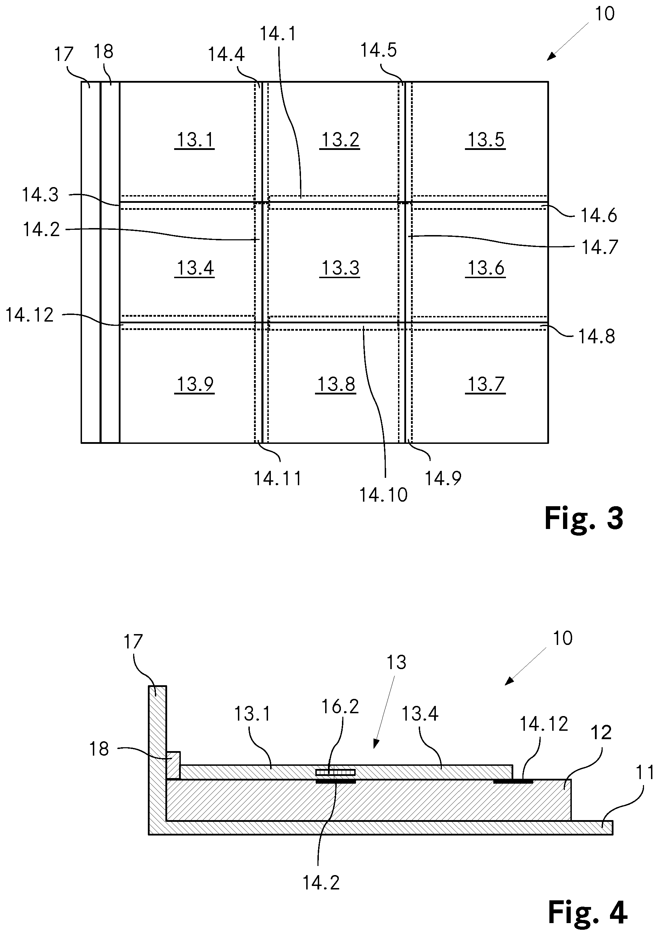

Fig. 3 shows a top view on an enlarged section of the floor structure 10. As shown in Fig. 3, the aluminum stripes 14.1, 14.2, ..., 14.12 (dashed rectangles) located below the plates 13.1, 13.2, ..., 13.9, are arranged in the form of a rectangular grid. Thereby, the aluminum stripes 14.1, 14.2, ..., 14.12 run along the lines of contact between the plates 13.1, 13,2, ..., 13.9.

All the aluminum stripes 14.1, 14.2, ..., 14.12 are adhesively bonded on their upper side with adhesive 15 (not shown in Fig. 3) to the lower side of the plates 13.1, 13,2, ..., 13.9, such that neighboring plates are interconnected by the aluminum stripes 14.1, 14.2, ..., 14.12.

All of neighboring plates 13.1, 13.2, ..., 13.9 are additionally interconnected by aluminum tongues (not shown in Fig. 3) as explained with Fig. 1.

Fig. 4 show a cross-section of the floor structure 10 of Fig. 1 along line A - A in Fig. 1.

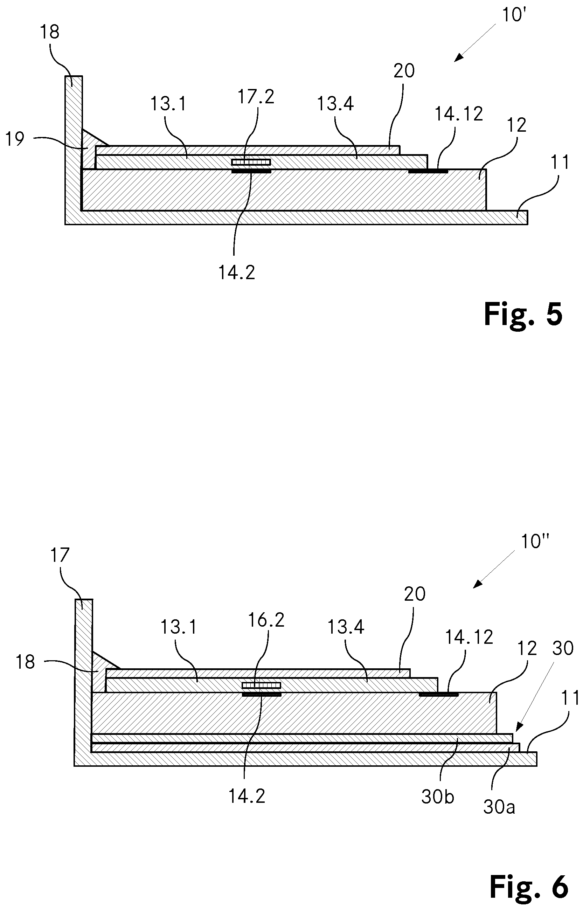

Fig. 5 shows a cross-section of a further floor structure 10'. The floor structure 10' is essentially identical in design with the floor structure 10 of Fig. 1. However, on top of the constraining layer 13 as an additional covering layer 20, a watertight polyurethane-based resin (e.g. Sikafloor Marine 590, available from Sika Germany) is applied.

Fig. 6 shows a cross-section of another floor structure 10". The floor structure 10" is similar in design with the floor structure 10' but additionally comprises an interlayer 30 between the supporting element 11 and the insulating layer 12. The interlayer 30 consists of a lower layer 30a made from a polymer modified cementitious mortar (e.g. Sikafloor^{®} Marine VEM, available from Sika Germany) as a viscoelastic layer and an upper layer 30b made from another polymer modified cementitious mortar (e.g. Sikafloor^{®} Marine-190, available from Sika Germany) as an additional constraining layer.

It will be appreciated by those skilled in the art that the present invention can be embodied in other specific forms without departing from the spirit or essential characteristics thereof. The presently disclosed embodiments are therefore considered in all respects to be illustrative and not restricted.

For example, instead of the upper layer 30b made from polymer modified cementitious mortar, steel tiles might be used.

Also, additional primer layers (e.g. Sikafloor^{®} Marine Primer C, available from Sika Germany) might be applied in between the upper layer 30b and the lower layer 30a, as well as between the lower layer 30a and the supporting element 11 in order to improve adhesion between the layers.

### Fire tests

Fire tests with the floor structure have been performed in line with the international code for application of fire test procedures, 2010 (International Maritime Organization, resolution msc.307(88), adopted on 3 December 2010.

The tests have shown that the setup prevents the passage of flame and smoke for 60 minutes. An average temperature rise on the unexposed deck side was less than 140 °C above the temperature before starting the standard fire test. Overall, the with the inventive mortar composition it is possible to produce class A-60 type decks.

### Acoustic tests

Acoustic tests have been performed according to standard ISO 10140:2010 and EN ISO 717:2013. All of the tested floor structures clearly showed a significant noise and vibration suppression.

### Load capacity

For testing the load capacity, cars with a weight of about 2 tons were loaded in the floors. Thereby, no lasting deformations or damages could be observed.

In summary, the inventive floor structures can be used for producing effective fire barriers and acoustic damping while having load capacities that are comparable with known floor structures but at a much lower weight.

## Claims

1. Floor structure (10, 10', 10") comprising:
(i) a supporting element (11), especially made of metal;
(ii) an insulating layer (12) made of mineral wool;
(iii) a constraining layer (13) made of a metal sandwich structure comprising a first (131) and a second metal cover layer (132), whereby between the first (131) and the second cover layer (132) a core layer (133) having a corrugated structure is arranged, such that between the first cover layer (131) and the core layer (133) first channels (134) and between the second cover layer (132) and the core layer (133) second channels (135) are formed,
**characterized in that** said insulating layer (12) is arranged between said supporting element (11) and said constraining layer (13).

2. Floor structure according to claim 1, wherein the supporting element (11) is a deck of a ship or an offshore installation, especially made of steel and/or aluminum.

3. Floor structure according to any of preceding claims, wherein the insulating layer (12) is made of mineral wool with one or more of the following properties:
- a nominal density, measured according to EN 1602:2013, of 70 - 200 kg/m³, preferably 90 - 190 kg/m³, in particular 100 - 170 kg/m³, especially 120 - 150 kg/m², for example 140 kg/m³ and/or
- a compressive strength, measured according to EN 826:2013, of at least 4 kPa, preferably at least 7 kPa, in particular at least 10 kPa, especially at least 12 kPa and/or
- a thickness, measured in direction perpendicular to the support element, of 30 - 150 mm, especially 40 - 100 mm, in particular 45 - 60 mm, for example 50 mm, and/or
- a dynamic stiffness, measured according to EN 229052-1:1992, of 3 - 20 MN/m³, preferably 8 - 19 MN/m³, especially 10 - 17 MN/m³, in particular 12 - 16 MN/m³, for example 14 MN/m³.

4. Floor structure according to any of preceding claims whereby a thickness of the constraining layer (13) and/or the metal sandwich structure is 2 - 25 mm, especially 3 - 15 mm, in particular 5 - 10 mm.

5. Floor structure according to any of preceding claims whereby the first metal cover layer (131), the second metal cover layer (132) and/or the core layer having a corrugated structure (133) is/are made of aluminum.

6. Floor structure according to any of preceding claims whereby:
- a thickness of the first metal cover layer (131) and/or the second metal cover layer (132) is 0.5 - 2 mm, especially 0.7 - 1.3 mm, in particular 0.9 -1.1 mm,
- a thickness of the core layer (133) is 0.1 - 0.5 mm, especially 0.2 - 0.4 mm, for example 0.3 mm,
- a thickness of the first metal cover layer (131) and/or the second metal cover layer (132) is larger than the thickness of the core layer (133).

7. Floor structure according to any of preceding claims whereby the core layer (133), in a plane perpendicular to the longitudinal axes of the channels (134, 135), has a sinusoidal cross-section.

8. Floor structure according to any of preceding claims, wherein the metal sandwich structure comprises 3 - 20 channels (134, 135) per meter, especially 4 - 15 channels per meter, whereby the channels include the total of the first (134) and the second channels (135).

9. Floor structure according to any of preceding claims, whereby the constraining layer (13) is made of several individual plates (13.1, 13.2, ...), especially rectangular plates, having a metal sandwich structure, whereby the individual plates (13.1, 13.2, ...) are connected to each other with a tongue and groove connection, whereby, preferably, the individual plates (13.1, 13.2, ...) on each side comprise a groove within the sidewall in which an additional metal tongue (16.1, 16.2, ...) is placed that extends into the groove of a neighboring plate.

10. Floor structure according to any of preceding claims, whereby between the mineral wool of the insulating layer (12) and the metal sandwich structure of the constraining layer (13) metal stripes (14.1, 14.2, ...), especially aluminum stripes, are arranged in a grid-like manner, whereby the metal stripes (14.1, 14.2, ...) are adhesively bonded to the metal sandwich structure, especially with a polyurethane adhesive (15).

11. Floor structure according to any of preceding claims, whereby a coverage of the metal stripes (14.1, 14.2, ...) is 5 - 50%, especially 10 - 30%, of the total surface area of the insulating layer (12).

12. Floor structure according to any of claims 9 - 11, whereby the metal stripes (14.1, 14.2, ...) are arranged such that neighboring individual plates (13.1, 13.2, ...) having a metal sandwich structure are connected via at least one metal stripe (14.1, 14.2, ...).

13. Floor structure according to any of preceding claims, whereby in between the supporting element (11) and the insulating layer (12), at least one interlayer (30) is arranged, whereby the interlayer (30) is selected from a primer, a mortar and/or metal tiles.

14. Floor structure according to any of preceding claims, whereby on top of the constraining layer (13), at least one covering layer (20) is arranged, whereby the covering layer (20) preferably is selected from organic resins and tiles.

15. A vehicle, a building and/or an offshore installation, especially a ship, comprising a floor structure (10, 10', 10") according to any of claims 1 - 14.

16. Use of a floor structure (10, 10', 10") according to any of claims 1 - 14 for acoustic damping, in particular in a vehicle, a building and/or an offshore installation, especially in a ship, and/or use of the floor structure (10, 10', 10") in a fire protection system, especially as a firewall and/or a fire barrier, in particular in a vehicle, a building and/or an offshore installation, especially in a ship.

## Patentansprüche

1. Bodenstruktur (10, 10', 10") umfassend:
(i) ein Trägerelement (11), insbesondere aus Metall;
(ii) eine Isolierschicht (12) aus Mineralwolle;
(iii) eine Beschränkungsschicht (13) aus einer Metall-Sandwichstruktur, die eine erste (131) und eine zweite Metall-Deckschicht (132) umfasst, wobei zwischen der ersten (131) und der zweiten Deckschicht (132) eine Kernschicht (133) mit einer gewellten Struktur angeordnet ist, so dass zwischen der ersten Deckschicht (131) und der Kernschicht (133) erste Kanäle (134) und zwischen der zweiten Deckschicht (132) und der Kernschicht (133) zweite Kanäle (135) gebildet sind,
**dadurch gekennzeichnet, dass** die Isolationsschicht (12) zwischen dem Trägerelement (11) und der Beschränkungsschicht (13) angeordnet ist.

2. Bodenstruktur nach Anspruch 1, wobei das Trägerelement (11) ein Deck eines Schiffes oder einer Offshore-Anlage, insbesondere aus Stahl und/oder Aluminium, ist.

3. Bodenstruktur nach einem der vorstehenden Ansprüche, wobei die Isolationsschicht (12) aus Mineralwolle mit einer oder mehreren der folgenden Eigenschaften besteht:
- einer Nenndichte, gemessen nach EN 1602:2013, von 70 - 200 kg/m³, vorzugsweise 90 - 190 kg/m³, insbesondere 100 - 170 kg/m³, speziell 120 - 150 kg/m², beispielsweise 140 kg/m³, und/oder
- einer Druckfestigkeit, gemessen nach EN 826:2013, von wenigstens 4 kPa, vorzugsweise wenigstens 7 kPa, insbesondere wenigstens 10 kPa, speziell wenigstens 12 kPa, und/oder
- einer in Richtung senkrecht zu dem Trägerelement gemessenen Dicke von 30 - 150 mm, speziell 40 - 100 mm, insbesondere 45 - 60 mm, beispielsweise 50 mm, und/oder
- einer dynamischen Steifigkeit, gemessen nach EN 229052-1:1992, von 3 - 20 MN/m³, vorzugsweise 8 - 19 MN/m³, speziell 10 - 17 MN/m³, insbesondere 12 - 16 MN/m³, beispielsweise 14 MN/m³.

4. Bodenstruktur nach einem der vorstehenden Ansprüche, wobei eine Dicke der Beschränkungsschicht (13) und/oder der Metall-Sandwichstruktur 2 - 25 mm, speziell 3 - 15 mm, insbesondere 5 - 10 mm, beträgt.

5. Bodenstruktur nach einem der vorstehenden Ansprüche, wobei die erste Metall-Deckschicht (131), die zweite Metall-Deckschicht (132) und/oder die Kernschicht mit einer gewellten Struktur (133) aus Aluminium bestehen.

6. Bodenstruktur nach einem der vorstehenden Ansprüche, wobei:
- eine Dicke der ersten Metall-Deckschicht (131) und/oder der zweiten Metall-Deckschicht (132) 0,5 - 2 mm, speziell 0,7 - 1,3 mm, insbesondere 0,9 - 1,1 mm, beträgt,
- eine Dicke der Kernschicht (133) 0,1 - 0,5 mm, speziell 0,2 - 0,4 mm, beispielsweise 0,3 mm, beträgt,
- eine Dicke der ersten Metall-Deckschicht (131) und/oder der zweiten Metall-Deckschicht (132) größer als die Dicke der Kernschicht (133) ist.

7. Bodenstruktur nach einem der vorstehenden Ansprüche, wobei die Kernschicht (133) in einer Ebene senkrecht zu den Längsachsen der Kanäle (134, 135) einen sinusförmigen Querschnitt aufweist.

8. Bodenstruktur nach einem der vorstehenden Ansprüche, wobei die Metall-Sandwichstruktur 3 - 20 Kanäle (134, 135) pro Meter umfasst, insbesondere 4 - 15 Kanäle pro Meter, wobei die Kanäle die Summe der ersten (134) und der zweiten Kanäle (135) enthalten.

9. Bodenstruktur nach einem der vorstehenden Ansprüche, wobei die Beschränkungsschicht (13) aus mehreren Einzelplatten (13.1, 13.2, ...), insbesondere rechteckigen Platten, mit einer Metall-Sandwichstruktur besteht, wobei die Einzelplatten (13.1, 13.2, ...) durch eine Nut- und Federverbindung miteinander verbunden sind, wobei vorzugsweise die Einzelplatten (13.1, 13.2, ...) an jeder Seite eine Nut innerhalb der Seitenwand aufweisen, in die eine zusätzliche Metallfeder (16.1, 16.2, ...) platziert wird, die sich in die Nut einer benachbarten Platte erstreckt.

10. Bodenstruktur nach einem der vorstehenden Ansprüche, wobei zwischen der Mineralwolle der Isolierschicht (12) und der Metall-Sandwichstruktur der Beschränkungsschicht (13) Metallstreifen (14.1, 14.2, ...), insbesondere Aluminiumstreifen, auf gitterartige Weise angeordnet sind, wobei die Metallstreifen (14.1, 14.2, ...) mit der Metall-Sandwichstruktur verklebt sind, insbesondere mit einem Polyurethankleber (15).

11. Bodenstruktur nach einem der vorstehenden Ansprüche, wobei eine Bedeckung der Metallstreifen (14.1, 14.2, ...) 5 - 50 %, speziell 10 - 30 %, der Gesamtfläche der Isolierschicht (12) beträgt.

12. Bodenstruktur nach einem der Ansprüche 9 - 11, wobei die Metallstreifen (14.1, 14.2, ...) so angeordnet sind, dass benachbarte Einzelplatten (13.1, 13.2, ...) mit einer Metall-Sandwichstruktur über wenigstens einen Metallstreifen (14.1, 14.2, ...) verbunden sind.

13. Bodenstruktur nach einem der vorstehenden Ansprüche, wobei zwischen dem Trägerelement (11) und der Isolierschicht (12) wenigstens eine Zwischenschicht (30) angeordnet ist, wobei die Zwischenschicht (30) aus einer Grundierung, einem Mörtel und/oder Metallfliesen ausgewählt ist.

14. Bodenstruktur nach einem der vorstehenden Ansprüche, wobei auf der Beschränkungsschicht (13) wenigstens eine Deckschicht (20) angeordnet ist, wobei die Deckschicht (20) vorzugsweise aus organischen Harzen und Fliesen ausgewählt ist.

15. Fahrzeug, Gebäude und/oder Offshore-Anlage, insbesondere ein Schiff, umfassend eine Bodenstruktur (10, 10', 10") nach einem der Ansprüche 1 - 14.

16. Verwendung einer Bodenstruktur (10, 10', 10") nach einem der Ansprüche 1 - 14 zur akustischen Dämpfung, insbesondere in einem Fahrzeug, einem Gebäude und/oder einer Offshore-Anlage, insbesondere in einem Schiff, und/oder Verwendung der Bodenstruktur (10, 10', 10") in einem Brandschutzsystem, insbesondere als Brandwand und/oder Brandsperre, insbesondere in einem Fahrzeug, einem Gebäude und/oder einer Offshore-Anlage, speziell in einem Schiff.

## Revendications

1. Structure de plancher (10, 10', 10") comprenant :
(i) un élément de support (11), tout particulièrement constitué de métal ;
(ii) une couche isolante (12) constituée de laine minérale ;
(iii) une couche de contrainte (13) constituée d'une structure sandwich métallique comprenant une première (131) et une deuxième couche de recouvrement métallique (132), une couche centrale (133) présentant une structure ondulée étant disposée entre la première (131) et la deuxième couche de recouvrement (132), de sorte qu'entre la première couche de recouvrement (131) et la couche centrale (133), de premiers canaux (134), et entre la deuxième couche de recouvrement (132) et la couche centrale (133), de deuxièmes canaux (135) sont formés, **caractérisée en ce que** ladite couche isolante (12) est disposée entre ledit élément de support (11) et ladite couche de contrainte (13).

2. Structure de plancher selon la revendication 1, dans laquelle l'élément de support (11) est un pont d'un navire ou d'une installation en mer, tout particulièrement constitué d'acier et/ou d'aluminium.

3. Structure de plancher selon l'une quelconque des revendications précédentes, dans laquelle la couche isolante (12) est constituée de laine minérale dotée d'une ou plusieurs des propriétés suivantes :
- une masse volumique nominale, mesurée conformément à la norme EN 1602:2013, de 70-200 kg/m³, de préférence 90-190 kg/m³, en particulier 100-170 kg/m³, tout particulièrement 120-150 kg/m², par exemple 140 kg/m³, et/ou
- une résistance à la compression, mesurée conformément à la norme EN 826:2013, d'au moins 4 kPa, de préférence au moins 7 kPa, en particulier au moins 10 kPa, tout particulièrement au moins 12 kPa, et/ou
- une épaisseur, mesurée dans la direction perpendiculaire à l'élément de support, de 30-150 mm, en particulier 40-100 mm, tout particulièrement 45-60 mm, par exemple 50 mm, et/ou
- une rigidité dynamique, mesurée conformément à la norme EN 229052-1:1992, de 3-20 MN/m³, de préférence 8-19 MN/m³, en particulier 10-17 MN/m³, tout particulièrement 12-16 MN/m³, par exemple 14 MN/m³.

4. Structure de plancher selon l'une quelconque des revendications précédentes dans laquelle une épaisseur de la couche de contrainte (13) et/ou de la structure sandwich métallique est de 2-25 mm, en particulier 3-15 mm, tout particulièrement 5-10 mm.

5. Structure de plancher selon l'une quelconque des revendications précédentes dans laquelle la première couche de recouvrement métallique (131), la deuxième couche de recouvrement métallique (132) et/ou la couche centrale ayant une structure ondulée (133) sont constituées d'aluminium.

6. Structure de plancher selon l'une quelconque des revendications précédentes dans laquelle :
- une épaisseur de la première couche de recouvrement métallique (131) et/ou de la deuxième couche de recouvrement métallique (132) est de 0,5-2 mm, en particulier 0,7-1,3 mm, tout particulièrement 0,9-1,1 mm,
- une épaisseur de la couche centrale (133) est de 0,1-0,5 mm, tout particulièrement 0,2-0,4 mm, par exemple 0,3 mm,
- une épaisseur de la première couche de recouvrement métallique (131) et/ou de la deuxième couche de recouvrement métallique (132) est supérieure à l'épaisseur de la couche centrale (133).

7. Structure de plancher selon l'une quelconque des revendications précédentes dans laquelle la couche centrale (133), dans un plan perpendiculaire aux axes longitudinaux des canaux (134, 135), a une section transversale sinusoïdale.

8. Structure de plancher selon l'une quelconque des revendications précédentes, dans laquelle la structure sandwich métallique comprend 3-20 canaux (134, 135) par mètre, tout particulièrement 4-15 canaux par mètre, les canaux incluant le total des premier (134) et deuxième (135) canaux.

9. Structure de plancher selon l'une quelconque des revendications précédentes, dans laquelle la couche de contrainte (13) est constituée de plusieurs plaques individuelles (13.1, 13.2, ...), tout particulièrement de plaques rectangulaires, ayant une structure sandwich métallique, les plaques individuelles (13.1, 13.2, ...) étant assemblées les unes aux autres par un assemblage à rainure et languette, les plaques individuelles (13.1, 13.2, ...) comprenant de préférence sur chaque côté une rainure à l'intérieur de la paroi latérale dans laquelle est placée une languette métallique supplémentaire (16.1, 16.2, ...) qui s'étend à l'intérieur de la rainure d'une plaque voisine.

10. Structure de plancher selon l'une quelconque des revendications précédentes dans laquelle, entre la laine minérale de la couche isolante (12) et la structure sandwich métallique de la couche de contrainte (13), des bandes métalliques (14.1, 14.2, ...), tout particulièrement des bandes d'aluminium, sont disposées à la manière d'un quadrillage, les bandes métalliques (14.1, 14.2, ...) étant collées par adhésif à la structure sandwich métallique, tout particulièrement avec un adhésif à base de polyuréthane (15).

11. Structure de plancher selon l'une quelconque des revendications précédentes, dans laquelle un recouvrement des bandes métalliques (14.1, 14.2, ...) représente 5-50 %, tout particulièrement 10-30 %, de la superficie totale de la couche isolante (12).

12. Structure de plancher selon l'une quelconque des revendications 9 à 11, dans laquelle les bandes métalliques (14.1, 14.2, ...) sont disposées de telle sorte que des plaques individuelles voisines (13.1, 13.2, ...) ayant une structure sandwich métallique sont assemblées par au moins une bande métallique (14.1, 14.2, ...).

13. Structure de plancher selon l'une quelconque des revendications précédentes dans laquelle au moins une couche intercalaire (30) est disposée entre l'élément de support (11) et la couche isolante (12), la couche intercalaire (30) étant choisie parmi un apprêt, un mortier et/ou des carreaux métalliques.

14. Structure de plancher selon l'une quelconque des revendications précédentes, dans laquelle au moins une couche de recouvrement (20) est disposée au-dessus de la couche de contrainte (13), la couche de recouvrement (20) étant de préférence choisie parmi des résines organiques et des carreaux.

15. Véhicule, bâtiment et/ou installation en mer, tout particulièrement un navire, comprenant une structure de plancher (10, 10', 10") selon l'une quelconque des revendications 1 à 14.

16. Utilisation d'une structure de plancher (10, 10', 10") selon l'une quelconque des revendications 1 à 14 pour l'amortissement acoustique, en particulier dans un véhicule, un bâtiment et/ou une installation en mer, tout particulièrement dans un navire, et/ou utilisation de la structure de plancher (10, 10', 10") dans un système de protection contre les incendies, tout particulièrement comme pare-feu et/ou barrière anti-feu, en particulier dans un véhicule, un bâtiment et/ou une installation en mer, tout particulièrement dans un navire.
